# EUROPEAN PATENT APPLICATION

(11) **EP 1 422 261 A2**
(43) Date of publication of application: **26.05.2004**
(21) Application number: 03026171.3
(22) Date of filing: 17.11.2003
(51) Int. Cl.: C08K 5/098, C08K 5/3472

(54) **Flame-retardant thermosetting resin composition**

(30) Priority: 19.11.2002 JP 2002335684
(71) Applicant: MITSUBISHI GAS CHEMICAL COMPANY, INC., Chiyoda-ku, Tokyo 100-8324 (JP)
(72) Inventor: Mayama, Norikazu, Eiwa Chemical Industry Co., Ltd., Handa-city Aichi (JP); Yoshikawa, Akihiro Eiwa Chemical Industry Co.,Ltd., Handa-city Aichi (JP); Kato, Katsushige, Eiwa Chemical Industry Co., Ltd., Handa-city Aichi (JP); Kiriyama, Hiroyuki Eiwa Chemical Industry Co. Ltd., Handa-city Aichi (JP); Ishii, Kenji, Mitsubishi Gas Chemical Company, Inc, Tokyo (JP)
(74) Representative: HOFFMANN - EITLE

(57) **Abstract**

An object of the present invention is to provide a thermosetting resin composition which is acquired an excellent flame-retardancy without using any of halogen-based flame retardants, phosphorus-based flame retardants and antimony-based flame retardants and further without deteriorating chemical or physical properties which the thermosetting resin originally has.

The present invention is characterized in that a metal salt or an amine salt of a tetrazole compound which decomposes at a temperature of 300 °C or more and may generate nitrogen gas (A) is added independently, or an organic acid metal salt compound which may generate carbon dioxide gas by decomposition (B) is added together with said (A), or metal hydroxide (C) is further added together with said (A) or a combination of said (A) and (B) into thermosetting resin.

## Description

### BACKGROUND OF THE INVENTION

### 1) Field of the Invention

The present invention relates to a thermosetting resin composition having various uses as a molding material, and in particular, to a thermosetting resin composition having excellent flame-retardancy suitable for the use wherein the highly advanced flame-retardancy is required such as electric parts or electronic components.

### 2) Related Art

The technologies of using a tetrazole compound as a flame-retardant component are all intended for mixing in thermoplastic resin, and in many cases, halogenated compounds or phosphorus compounds are used as a flame retardant (see Japanese Publication Numbers JP,H7-304891-A, JP,2000-290484-A, and JP,2001-131324,A).

Although thermosetting resin is widely used as, for example, a molding material of electric parts or electronic materials such as a material of a substrate of a printed wiring board and flame-retardancy is severely required depending on a use, it is usually flammable by nature. Therefore, in order to give flame-retardancy as a conventional art, flame retardants such as halogenated compounds, phosphorus compounds, antimony compounds and metal hydroxide compounds which are used independently or mixed with each other had been generally mixed with a resin material and thereby the requirement had been satisfied.

However, it has become clear that the use of these conventional flame retardants may cause environmental problems such that they might generate environmental pollutant or poisonous gas at the time of combustion or that their metallic component might be a pollution source regarding the environmental sanitation. Therefore, the use is being restrained remarkably.

Moreover, when metal hydroxide is used as a flame retardant, the content of the metal hydroxide in material resin must be abundant in order to acquire an excellent flame-retardancy as intended, which might cause the deterioration of chemical or physical properties of the material resin remarkably. In particular, recently, it is tended from the aspect of environmental protection to restrain the use of a halogenated compound. Moreover, it is also tended to restrain the use of a phosphorus compound and an antimony compound in the field of electronic industry material.

In the case of using epoxy resin which is one of thermosetting resin as a material resin, a halogen-based flame retardant typified by tetrabromo bisphenol A (TBBA) is usually used as its flame-retardant component, and antimony trioxide which is a highly poisonous substance is used together as a flame retardant auxiliary. The halogen-based flame retardant is thermally decomposed at the time of combustion to generate hydrogen halide which acts as a radical capturing agent, and the hydrogen halide reacts with the antimony trioxide to generate antimony halide which acts as an interceptor of oxygen, whereby the spread of fire is considered to be prevented by these synergistic effects.

However, since a part of a halogen-based flame retardant changes to harmful organic halogen gas at the time of combustion, and in addition, the antimony trioxide as a flame retardant auxiliary is a poisonous substance with the doubt of having chronic toxicity, it is indicated that the use of these flame retardants or flame retardant auxiliaries has a problem in respect of environment and health.

As a substitute of the halogen-based flame retardant, a phosphorus-based flame retardant such as red phosphorus and phosphate ester is beginning to be used. The phosphorus-based flame retardant forms polyphosphoric acid at the time of combustion which covers the surface of carbonized layer of resin to intercept heat or supply of combustible gas such as oxygen, whereby the spread of fire is considered to be prevented. Although the phosphorus-based flame retardant is useful for imparting flame-retardancy to epoxy resin, such problems are pointed out that it reacts with the moisture of very small quantity to produce phosphine and corrosive phosphoric acid.

Metal hydroxide such as aluminum hydroxide and magnesium hydroxide and boron-based compounds may also be used as a flame retardant. The mechanisms of emerging the flame-retardant property by metal hydroxide is based on the combustion inhibitory action which lowers the resin temperature of the surface contact to flame by endothermic action accompanied by a dehydration reaction at the time of heating. However, the metal hydroxide has a fault that, in order to attain the level of flame-retardancy as high as a halogen-based or phosphorus-based flame retardant, it must be blended in large quantities to resin, which cause the deterioration of physical properties and moldability which the resin originally has.

### SUMMARY OF THE INVENTION

An object of the present invention is to provide a flame-retardant thermosetting resin composition containing a flame-retardant component which can impart an excellent flame-retardancy to thermosetting resin without using any of a halogen-based flame retardant, a phosphorus-based flame retardant and an antimony-based flame retardant.

Another object of the present invention is to provide a flame-retardant thermosetting resin composition as a molding material wherein an sufficient flame-retardancy can be imparted by adding a flame retardant in the amount of addition which does not deteriorate chemical or physical properties that the thermosetting resin originally has.

As a result of extensive studies about a flame retardant for imparting flame-retardancy to thermosetting resin, especially about a non-halogen-based flame retardant and a non-phosphorus-based flame retardant, the inventors have found that a flame retardant containing, as a major component, a metal salt or an amine salt of a tetrazole compound which decomposes at a temperature of 300 °C or more and may generate nitrogen gas surprisingly provides a significant improvement of flame-retardancy of thermosetting resin, and have accomplished the present invention.

That is, the present invention relates to a flame-retardant thermosetting resin composition described in the following 1) to 8).
1) A flame-retardant thermosetting resin composition which contains 100 parts by weight of thermosetting resin and 1 to 50 parts by weight of a metal salt or an amine salt of a tetrazole compound which decomposes at a temperature of 300 °C or more and may generate nitrogen gas.
2) The flame-retardant thermosetting resin composition according to 1), which further contains 0.1 to 40 parts by weight of an organic acid metal salt compound which may generate carbon dioxide gas by decomposition.
3) The flame-retardant thermosetting resin composition according to 1) or 2), which further contains 5 to 100 parts by weight of metal hydroxide.
4) The flame-retardant thermosetting resin composition according to 1) to 3), wherein said tetrazole compound is bistetrazole.
5) The flame-retardant thermosetting resin composition according to 2) to 4), wherein said organic acid metal salt compound is a metal salt compound of hydroxycarboxylic acid or polycarboxylic acid.
6) The flame-retardant thermosetting resin composition according to 3) to 5), wherein said metal hydroxide is aluminum hydroxide or magnesium hydroxide.
7) The flame-retardant thermosetting resin composition according to 1) to 6), wherein the average particle size of said tetrazole compound is 100 µm or less.
8) The flame-retardant thermosetting resin composition according to 2) to 7), wherein the average particle size of said organic acid metal salt compound is 100 µm or less.

### DETAILED DESCRIPTION OF THE INVENTION

The present invention will be hereinafter described in detail.

The present invention is characterized in that a thermosetting resin composition having an excellent flame-retardancy can be obtained by blending a metal salt or an amine salt of a tetrazole compound which decomposes at a temperature of 300 °C or more and may generate nitrogen gas (A) independently, by blending an organic acid metal salt compound which may generate carbon dioxide gas by decomposition (B) together with said (A), or by further blending metal hydroxide (C) together with said (A) or a combination of said (A) and (B) with a thermosetting resin.

What is important here is that the larger the amount of nitrogen gas generated from said metal salt or an amine salt of a tetrazole compound (A) at the time of combustion of material resin, the greater the contribution of the effect of blow off, whereby its flame-retardancy improves as a result. In the present invention, the term "an amine salt" includes a salt of an amino compound such as an ammonium salt and a salt of other nitrogen-containing compounds.

Examples of the metal salt or amine salt of a tetrazole compound (A) to be used in the present invention include a metal salt or an amine salt of bistetrazole and a metal salt of tetrazole which can deteriorate at a temperature of 300 °C or more. For example, examples of an amine salt of bistetrazole include 5,5'-bi-1H-tetrazole · diammonium, 5,5'-bi-1H-tetrazole · piperazine, 5,5'-bi-1H-tetrazole · diguanidine. Examples of a metal salt of bistetrazole include a monovalent or a divalent metal salt such as a salt of barium, calcium, magnesium, potassium, lithium, zinc, or sodium. More specifically, a salt of barium, calcium, potassium, lithium, zinc, or sodium of bistetrazole represented by the following general formula (1) and (2). In the formula(1) and (2), each of "a" and "b" shows a monovalent or a divalent metal atom respectively.

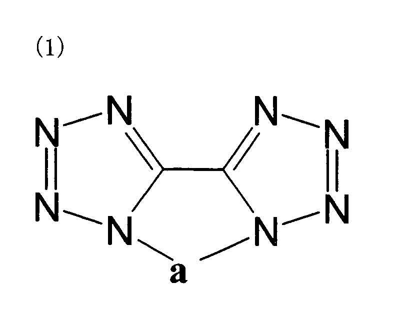

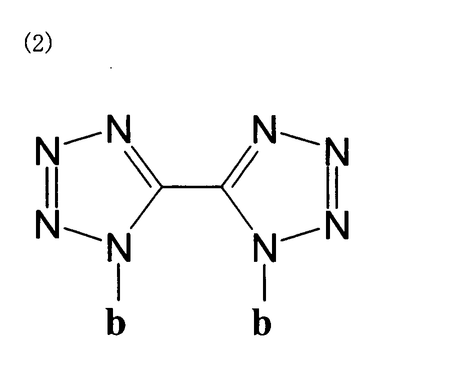

Examples of a metal salt of tetrazole include a monovalent or a divalent metal salt such as a salt of barium, calcium, magnesium, potassium, lithium, zinc, or sodium. More specifically, a salt of calcium, magnesium, sodium, or zinc of 5-amino-1H-tetrazole; a salt of lithium or zinc of 1H-tetrazole; a salt of calcium, lithium, zinc or sodium of 5-phenyl-1H-tetrazole. These metal salts or amine salts of a tetrazole compound may be used individually or two or more of them can be mixed.

The content of a metal salt or an amine salt of a tetrazole compound (A) in the composition of the present invention is selected from the range of 1 to 50 parts by weight, preferably 1 to 30 parts by weight based upon 100 parts by weight of thermosetting resin. When the content is too small, the effect of flame-retardancy may become insufficient, and when the content is too large, the properties of the composition may be deteriorated.

It is connected with the use of the flame-retardant thermosetting resin composition of the present invention that the metal salt or amine salt of a tetrazole compound used in the present invention needs a decomposition temperature of 300 °C or more. That is, if the metal salt or amine salt of a tetrazole compound decomposes at a temperature lower than 300 °C, it may become, for example, the cause of defects in soldering of a printed circuit of a wiring board using thermosetting resin as material resin, or may become the cause of damages of moldability by forming decomposition gas at the time of curing molding.

As for the organic acid metal salt compound (B) to be used in the present invention, the compound which can generate large amount of carbon dioxide gas by decomposition at the time of combustion contributes to the improvement of flame-retardancy.

Examples of organic acid composing preferable organic acid metal salt compounds include hydroxycarboxylic acid and polycarboxylic acid. Examples of hydroxycarboxylic acid include monohydroxy monocarboxylic acid, monohydroxy polycarboxylic acid such as monohydroxy dicarboxylic acid and monohydroxy tricarboxylic acid and polyhydroxy polycarboxylic acid such as dihydroxy dicarboxylic acid. Examples of polycarboxylic acid include dicarboxylic acid.

The carbon number of the organic acid is preferably around 2 to 20, more preferably around 2 to 10.

Examples of the metal salts of such organic acid include the salt of aluminum, tin, potassium, zinc and sodium.

More specifically, examples of the compound (B) include aluminum lactate, tin oxalate, zinc oxalate, zinc citrate, potassium bitartrate and sodium succinate.

These organic acid metal salt compounds can be used independently or two or more of them can be mixed to be used.

The content of the organic acid metal salt compound (B) in the composition of the present invention is selected from the range of 0.1 to 40 parts by weight, preferably 1 to 20 parts by weight based upon 100 parts by weight of thermosetting resin. When the content is too small, the effect of flame-retardancy may become insufficient, and when the content is too large, the properties of the composition may be deteriorated.

When metal hydroxide (C) is mixed in the mixture wherein the above-mentioned metal salt or amine salt of a tetrazole compound (A)is used independently, or in the mixture wherein said (A) and an organic acid metal salt compound (B) are combined to be used, the cooling effect by water generated from the metal hydroxide is added in addition to the effect of blow out and the effect of reducing inflammation by nitrogen gas and/or carbon dioxide gas generated at the time of combustion, and flame-retardancy improves remarkably by their synergistic effect.

In addition, it becomes possible to reduce the content of the compound (A) and (B) by addition of the compound (C), and the composition becomes economically advantageous.

As the metal hydroxide (C), aluminum hydroxide or magnesium hydroxide can be used suitably. The content of the metal hydroxide (C) is preferably selected out of the range of 5 to 100 parts by weight, more preferably 10 to 100 parts by weight based upon 100 parts by weight of thermosetting resin. When the content is too small, the effect of flame-retardancy may become insufficient, and when the content is too large, the properties of the composition may be deteriorated.

The flame-retardant component to be used in the present invention can be prepared by usual well-known methods. For example, when preparing the mixture of a metal salt or an amine salt of a tetrazole compound (A) and an organic acid metal salt compound (B), or the mixture wherein metal hydroxide (C) is further mixed with the mixture of (A) and (B), examples of the methods include a method of mixing these components homogeneously with a precision mixer.

When the above (A), (B) and (C) are blended with thermosetting resin as a flame retardant, it is preferred from the aspect of physical properties and the like that these flame-retardant compounds are distributed with the average particle size (diameter) of 100 µm or less in resin. Therefore, as for the metal salt or an amine salt of a tetrazole compound (A) and the organic acid metal salt compound (B), it is preferred that their average particle diameter is 100 µm or less, more preferably 1 to 50 µm, still more preferably 1 to 30 µm.

In the flame-retardant thermosetting resin composition of the present invention, the content of the flame-retardant component which is the sum total of (A), (B) and (C) is preferably selected from the range wherein both the effect of the improvement of flame-retardancy and the chemical and physical properties that the thermosetting resin originally has are not deteriorated. That is, the content of said flame-retardant component in the composition of the present invention is preferably selected from the range of 1 to 190 parts by weight, more preferably 2 to 130 parts by weight, most preferably 3 to 100 parts by weight based upon 100 parts by weight of thermosetting resin.

In the flame-retardant thermosetting resin composition of the present invention, the usual additives such as an antioxidant, a heat stabilizer, an ultraviolet absorber, a lubricant, a mold release agent, dye, pigments, a thickener, an antifoaming agent and a coupling agent can be added according to a request in the range which does not spoil the purpose of the present invention.

The thermosetting resin to be used in the present invention usually means a generic name of thermosetting resin, examples of which include epoxy resin, phenol resin, unsaturated polyester resin, urea resin, melamine resin, polyurethane, cyanate resin, bismaleimide resin and bismaleimide triazine resin (usually referred to in the name of "BT resin").

Examples of epoxy resin to be used in the present invention include bisphenol-A type epoxy resin, bisphenol-F type epoxy resin, bisphenol-Z type epoxy resin, a biphenol · epoxy resin, tetramethyl biphenol · epoxy resin, hexamethyl biphenol · epoxy resin, xylylene novolak epoxy resin, biphenyl novolak epoxy resin, dicyclopentadiene novolak epoxy resin, phenol novolak epoxy resin and cresol novolak epoxy resin. These epoxy resins can be used independently or two or more of them can be mixed or reacted mutually to be used as a composition or a reaction product.

A curing agent is usually used with the above-mentioned epoxy resin. Examples of the curing agent include an amine-based curing agent using primary amine or secondary amine and the like, a phenol-based curing agent such as bisphenol A, phenol novolak and the like, an acid anhydride-based curing agent and a cyanate ester-based curing agent. These curing agents can be used independently or two or more of them can be combined to be used.

Examples of phenol resin to be used in the present invention include novolak type phenol resin, resole type phenol resin and modified phenol resin. However, the phenol resin to be used is not specifically limited to them.

Examples of the unsaturated polyester resin to be used in the present invention generally include unsaturated polyester resin (a) having a relatively low molecular weight obtained by polycondensation reaction of unsaturated dicarboxylic acid and glycols, and unsaturated polyester resin (b) obtained by adding a vinyl monomer for crosslinking to said unsaturated polyester resin (a). However, unsaturated polyester resin to be used is not specifically limited to them.

Examples of polyurethane to be used in the present invention include a general type of polyurethane resin having urethane bond in a molecule obtained mostly by the reaction of diisocyanates with polyols. However, a polyurethane elastomer such as complete thermoplastic polyurethane which is a complete linear polyurethane high molecular compound wherein the active isocyanate group hardly exists and incomplete thermoplastic polyurethane wherein the active isocyanate group remains is not included.

### PREFERRED EMBODIMENT OF THE INVENTION

Hereinafter, the present invention will be described in more detail referring to embodiments which are not intended to limit the scope of the present invention.

Examination of flame-retardancy and measurement of a decomposition temperature of a metal salt or an amine salt of a tetrazole compound were carried out by the following method.

### [Examination of flame-retardancy]

A flame-retardant thermosetting resin composition containing a flame-retardant component of the present invention was fed into a mold for molding a test piece with a thickness of 1/16 inch. Then the mold was heated in a transfer press to obtain a molded test piece by curing. In the case of a laminate sheet, a test piece was obtained by cutting the laminate sheet itself in predetermined size.

Flame-retardancy was evaluated in accordance with the evaluation standard provided in the UL94 perpendicular method using the obtained test pieces. An examination was carried out with every five test pieces each. The result wherein the average reduction-of-inflammation time was not longer than 5 seconds and the longest reduction-of-inflammation time was not longer than 10 seconds was evaluated as UL94 "V-0", and the result wherein the average reduction-of-inflammation time was not longer than 25 seconds and the longest reduction-of-inflammation time was not longer than 30 seconds was evaluated as UL94 "V-1".

### [Method for measuring a decomposition temperature]

Measurement was carried out using the thermometric analysis device. A cell made from aluminum was used, and heating was started from 40 °C in a nitrogen gas stream. The temperature was raised then to 450 °C with the heating rate of 10°C/min. The peak of DTA (Differential Thermal Analysis) which indicates exothermic heat and endothermic heat was employed to determine a decomposition temperature.

### EXAMPLE 1

In the Example 1, a mixture wherein 10 parts by weight of 5,5'-bi-1H-tetrazole · piperazine having the decomposition temperature of 350 °C and the average particle size of 15 µm, 10 parts by weight of aluminum lactate having the average particle size of 20 µm and 50 parts by weight of aluminum hydroxide were mixed homogeneously was used as a flame-retardant component.

100 parts by weight of thermosetting resin which was the total weight of 40 parts by weight of phenol novolak resin and 60 parts by weight of phenol novolak type epoxy resin, 5 parts by weight of zinc molybdate, 5 parts by weight of epoxysilane, 0.5 parts by weight of a dispersing agent and 0.01 parts by weight of imidazole were mixed sufficiently to prepare a varnish composition.

Then, the varnish composition thus obtained and the above-mentioned flame-retardant component were mixed and fully kneaded together to obtain a test composition.

The test composition thus obtained was applied to a glass cloth "7628-SV657" having a thickness of 0.2 mm manufactured by Arisawa Mfg. Co., Ltd. to prepare a prepreg.

Four sheets of the prepreg thus obtained was laminated together using a 200°C-press under the condition of heating the press with the heating rate of 3°C/min to a temperature of 200 °C and keeping the temperature at 200 °C for 60 minutes to obtain a laminate sheet.

The examination of flame-retardancy was carried out using the laminate sheet thus obtained, and the result was shown as "V-1".

### EXAMPLE 2

Except for using 75 parts by weight of aluminum hydroxide, a laminate sheet was obtained in the same manner as in Example 1, and the examination of flame-retardancy was carried out. The result was shown as "V-0".

### EXAMPLE 3

A mixture wherein 10 parts by weight of 5-amino-1H-tetrazole sodium salt having the decomposition temperature of 340 °C and the average particle size of 10 µm, 10 parts by weight of tin oxalate having the average particle size of 15 µm and 50 parts by weight of aluminum hydroxide were mixed homogeneously was used as a flame-retardant component.

A laminate sheet was obtained in the same manner as in Example 1 except for using the above-mentioned flame-retardant component. The examination of flame-retardancy was carried out and the result was shown as "V-1".

### EXAMPLE 4

Except for using 75 parts by weight of aluminum hydroxide, a laminate sheet was obtained in the same manner as in Example 3, and the examination of flame-retardancy was carried out. The result was shown as "V-0".

### EXAMPLE 5

Except for using the mixture of 20 parts by weight of 5-amino-1H-tetrazole zinc salt having the decomposition temperature of 360 °C and the average particle size of 10 µm and 75 parts by weight of aluminum hydroxide as a flame-retardant component, a laminate sheet was obtained in the same manner as in Example 3 and the examination of flame-retardancy was carried out. The result was shown as "V-0".

### EXAMPLE 6

An epoxy resin composition was prepared by mixing raw materials including 184 parts by weight of thermosetting resin which was a total weight of 100 parts by weight of biphenyl type epoxy resin having epoxy equivalent of 195 eq/g and 84 parts by weight of phenol novolak resin as a curing agent, 1.8 parts by weight of 2-methyl imidazole as a curing catalyst, 800 parts by weight of molten silica having the average particle size of 10 µm, 3 parts by weight of γ-glycidoxy propyl triethoxysilane as a coupling agent, 1 part by weight of montanic acid ester as a mold release agent and 6 parts by weight of 5,5'-bi-1H-tetrazole · diammonium having the decomposition temperature of 370 °C and the average particle size of 15 µm as a flame-retardant component.

The mixture of the above raw materials was kneaded by a roll for about 20 minutes and then grinded by a grinder. Afterwards, tablets were formed using the mixture to obtain an epoxy resin molding composition as a form of tablets.

A molded form was obtained by using the molding composition thus obtained and the examination of flame-retardancy was carried out. The result was shown as "V-0".

### EXAMPLE 7

Except for using 5-amino-1H-tetrazole · calcium having the decomposition temperature of 370°C and the average particle size of 15µm as a flame-retardant component, a molded form was obtained in the same manner as in Example 6, and the examination of flame retardancy was carried out. The result was shown as "V-0".

### EXAMPLE 8

A mixture wherein 7 parts by weight of 5,5'-bi-1H-tetrazole·calcium having the decomposition temperature of 470 °C and the average particle size of 20 µm and 7 parts by weight of zinc citrate having the average particle size of 30 µm were mixed homogeneously was used as a flame-retardant component.

A polyurethane resin composition was prepared by mixing a polyol component comprising 10 parts by weight of ethylenediamine-based polyetherpolyol, 5.9 parts by weight of ethylenediamine/sucrose-based polyetherpolyol, 11 parts by weight of Mannich-type polyetherpolyol, 16 parts by weight of phthalic acid/ dipropyleneglycol-based polyesterpolyol, and 19 parts by weight of phthalic acid/dibutyleneglycol-based polyesterpolyol, a catalyst component comprising 1.2 parts by weight of N, N', N''-tris(dimethylaminopropyl) hexahydro-S-triazine, 1.7 parts by weight of a diethyleneglycol solution of potassium octylate at the concentration of 50%, 0.2 parts by weight of a terpin solution of lead octylate and a polyisocyanate component comprising 100 parts by weight of crude diphenylmethane diisocyanate.

The above-mentioned flame-retardant component was added to 100 parts by weight of the polyurethane resin composition thus obtained, and then a spray coating was carried out to obtain a molded form. The examination of flame retardancy was carried out for the molded form and the result was shown as "V-0".

### EXAMPLE 9

A mixture wherein 2.5 parts by weight of 5,5'-bi-1H-tetrazole · diguanidine having the decomposition temperature of 350 °C and the average particle size of 10 µm, 2.5 parts by weight of potassium bitartrate having the average particle size of 10 µm and 5 parts by weight of magnesium hydroxide were mixed homogeneously was used as a flame-retardant component.

A liquid composition was prepared by mixing 100 parts by weight of "POLYMAL820P" manufactured by Takeda Chemical Industries, Ltd. as an unsaturated polyester resin, 1.5 parts by weight of methylethylketone peroxide as a curing agent and 1 part by weight of cobalt naphthenate to obtain a mixture and then adding the above-mentioned flame-retardant component to the mixture.

The liquid composition thus obtained was fed into a die and then it was heated at the temperature of 110 °C for one hour to obtain a completely cured formed product. The examination of flame-retardancy was carried out for the formed product thus obtained and the result was shown as "V-0".

A formed product obtained by using the flame-retardant thermosetting composition of the present invention has features that toxic gas which might become a cause of environmental pollution is not generated at the time of combustion. Thus, it is useful as a material of various formed products, especially a material of electronic components or electric parts, for example, as a sealant for electronic components or a varnish material for laminate sheets.

## Claims

1. A flame-retardant thermosetting resin composition which contains 100 parts by weight of thermosetting resin and 1 to 50 parts by weight of a metal salt or an amine salt of a tetrazole compound which decomposes at a temperature of 300°C or more and may generate nitrogen gas.

2. The flame-retardant thermosetting resin composition according to Claim 1, which further contains 0.1 to 40 parts by weight of an organic acid metal salt compound which may generate carbon dioxide gas by decomposition.

3. The flame-retardant thermosetting resin composition according to Claim 1 or 2, which further contains 5 to 100 parts by weight of metal hydroxide.

4. The flame-retardant thermosetting resin composition according to Claim 1 to 3, wherein said tetrazole compound is bistetrazole.

5. The flame-retardant thermosetting resin composition according to Claim 2 to 4, wherein said organic acid metal salt compound is a metal salt compound of hydroxycarboxylic acid or polycarboxylic acid.

6. The flame-retardant thermosetting resin composition according to Claim 3 to 5, wherein said metal hydroxide is aluminum hydroxide or magnesium hydroxide.

7. The flame-retardant thermosetting resin composition according to Claim 1 to 6, wherein the average particle size of said tetrazole compound is 100 µm or less.

8. The flame-retardant thermosetting resin composition according to Claim 2 to 7, wherein the average particle size of said organic acid metal salt compound is 100 µm or less.
